# EUROPÄISCHE PATENTANMELDUNG

(11) **EP 2 467 003 A2**
(43) Veröffentlichungstag der Anmeldung: **20.06.2012**
(21) Anmeldenummer: 11009842.3
(22) Anmeldetag: 14.12.2011
(51) Int. Cl.: H05K 3/46

(54) **Leiterplatte und Verfahren zur Herstellung von Leiterplatten**

(30) Priorität: 20.12.2010 DE 102010054974
(71) Anmelder: Schoeller-Electronics GmbH, 35083 Wetter / Hessen (DE)
(72) Erfinder: Wille, Markus, 59199 Bönen (DE)
(74) Vertreter: Gottschald, Jan

(57) **Zusammenfassung**

Die Erfindung betrifft eine Leiterplatte (1) mit mindestens einem biegbaren Bereich (2), der eine biegbare Lage (4), die ein- oder beidseitig mit einer Kupferkaschierung (11) oder mit Leiterbahnen versehen ist, aufweist, wobei die biegbare Lage (4) zumindest in dem biegbaren Bereich (2) und zumindest einseitig mit einer Deckschicht (8) versehen ist. Die Deckschicht (8) ist aus einem Prepreg-Material (5) gebildet.

## Beschreibung

Die Erfindung betrifft eine Leiterplatte nach dem Oberbegriff von Anspruch 1, und ein Verfahren zur Herstellung von Leiterplatten.

Im Stand der Technik sind gedruckte elektrische Schaltungen bekannt, bei denen Leiterplatten mit elektronischen Bauelementen bestückt sind. Solche Leiterplatten können aus einer oder mehreren Einzellagen von glasfaserverstärkten, ausgehärteten Epoxidharz-Platten bestehen, die zur Ausbildung von Leiterbahnen ein- oder beidseitig kupferkaschiert sind.

Leiterplatten als solche können starr ausgebildet sein. Desweiteren sind Leiterplatten, die zumindest einen starren Bereich und zumindest einen biegbaren bzw. flexiblen Bereich aufweisen, seit langem als sogenannte starr-flexible Leiterplatten bekannt. Verschiedene starre Bereiche sind hierbei durch flexible Bereiche miteinander elektrisch verbunden. Das Material der flexiblen Bereiche besteht in der Regel aus flexiblen Kunststofffolien (z.B. Polyimid), die kupferkaschiert sind. Die flexiblen Bereiche solcher starr- flexiblen Leiterplatten überstehen dynamische Biegebeanspruchungen mit einer hohen Anzahl von Biegezyklen. Jedoch ist es nicht notwendig, stets ein hochflexibles Material für die Biegebereiche der Leiterplatte zu verwenden, da die Leiterplatte nur wenige Male während der Montage und/oder zu Reparaturzwecken gebogen wird.

Aus DE 41 31 935 A1 ist ein Verfahren zur Herstellung einer starr-biegbaren Leiterplatte bekannt. Bei diesem Verfahren wird der starre Bereich, der aus einem starren Basismaterial besteht, durch Tiefenfräsen soweit in seiner Dicke reduziert, bis das verbleibende Material aufgrund der verminderten Dicke gebogen werden kann und dadurch der biegbare Bereich entsteht. Ein Nachteil von Leiterplatten, die nach diesem Verfahren hergestellt werden, besteht darin, dass die biegbaren Bereiche sich nur wenige Male mit einem relativ großen Radius biegen lassen. Desweiteren befinden sich die biegbaren Bereiche asymmetrisch auf nur einer Außenseite der resultierenden Leiterplatte.

Aus DE 42 06 746 C1 ist ein Verfahren zur Herstellung von starr-biegbaren Leiterplatten bekannt. Bei diesem Verfahren wird anstelle einer teuren biegbaren Einzellage ein preisgünstigeres dünnes Prepreg-Material verwendet, das auch nach der Aushärtung noch gebogen werden kann. Zwischen einer starren Außenlage und dem Prepreg-Material wird im später herausbrechbaren Abschnitt der Leiterplatte, aus dem der biegbare Bereich gebildet wird, vor dem Verpressen eine Isolationsfolie eingelegt, die nicht an Kupfer anhaftet. Falls bei diesem Verfahren der biegbare Bereich aus zwei oder mehr Lagen gebaut ist, besteht ein Nachteil darin, dass das Prepreg-Material zunächst in einem kostenintensiven Laminiervorgang mit den Kupferlagen beschichtet werden muss.

Ähnlich zu DE 42 06 746 C1 werden von der Fa. Teledyne Leiterplatten mit biegbaren Bereichen unter dem Namen, "REGAL®Flex" hergestellt.

Aus DE 40 03 344 C1 ist eine gattungsbildende starr-biegbare Leiterplatte bekannt, die einen biegbaren Bereich und einen starren Bereich aufweist. Eine Kupferfolie wird mittels einer Klebefolie in Form eines Prepreg-Materials mit einer starren Einzellage verbunden. In dem später biegbaren Bereich der Leiterplatte ist eine Isolationsfolie in Form einer Polyimidfolie vorgesehen, die als Basisfolie des flexiblen Bereichs dient. Nach einem Verpressen der Lagen unter Druck und Hitze wird die Kupferfolie mit der Polyimidfolie und der starren Einzellage dauerhaft und lötbadbeständig verbunden bzw. verklebt. Der biegbare Bereich wird dadurch erzielt, dass in diesem Bereich die starre Einzellage durch vorgebildete Sollbruchstellen entfernt wird. Zusätzlich ist in dem flexiblen Bereich auf einer Außenseite der Kupferfolie eine Abdeckung in Form eines Deckfolien-Stücks vorgesehen, das die Leiterbahnen dieser Kupferfolie abdeckt. Das Verfahren zur Herstellung einer Leiterplatte nach diesem Stand der Technik ist in Folge einer Vielzahl von einzelnen Verfahrensschritten aufwendig und damit teuer.

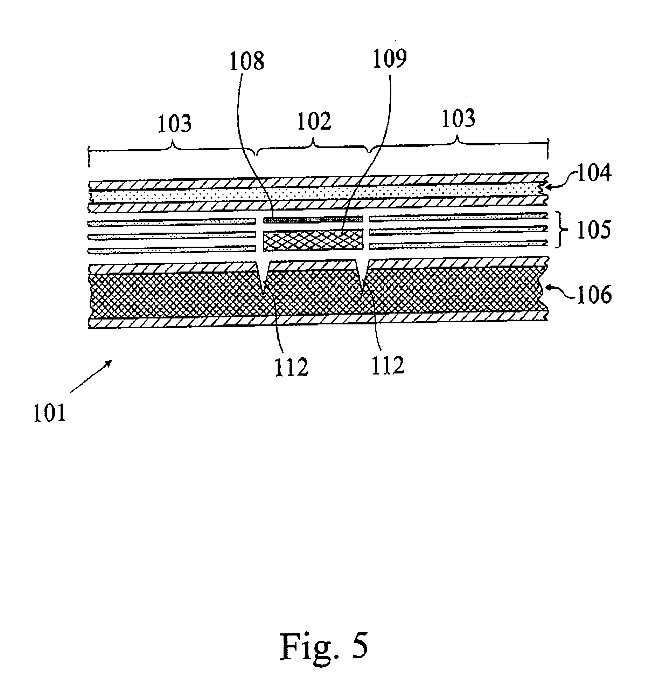

Fig. 5 zeigt vereinfacht den Schichtaufbau einer herkömmlichen Leiterplatte 101 vor dem Durchführen eines Heißpressvorgangs. Eine solche Leiterplatte 101 weist eine biegbare Lage 104 und eine starre Lage 106 auf. Im fertiggestellten Zustand weist eine solche Leiterplatte 101 einen biegbaren Bereich 102 auf, der zwei daran angrenzende starre Bereiche 103 miteinander verbindet. Vor dem Durchführen eines Heißpressvorgangs werden zwischen der biegbaren Lage 104 und der starren Lage 106 eine Mehrzahl von Prepreg-Lagen 105 angeordnet. Im Hinblick auf ein vereinfachtes Handling bestehen diese Prepreg-Lagen 105 vorzugsweise aus No-Flow-Prepregs.

In einem vorbestimmten Flächenabschnitt der Leiterplatte 101, der einem späteren biegbaren Bereich 102 entspricht, sind eine separate Deckschicht 108 und angrenzend an die starre Lage 106 eine Trennfolie in Form einer Teflon-Folie 109 angeordnet. Im Verlauf des Heißpressvorgangs werden die biegbare Lage 104 und die starre Lage 106 mittels der Prepregs 105 miteinander verbunden bzw. verklebt, wobei die in dem vorbestimmten Flächenabschnitt angeordnete Teflonfolie 109 nicht bzw. nur schlecht an der Deckschicht 108 anhaftet. An den Rändern des vorbestimmten Flächenabschnitts der Leiterplatte 101 sind in der starren Lage 106 Sollbruchstellen 112 vorgesehen. Diese Sollbruchstellen 112 erleichtern nach Abschluss des Heißpressvorgangs ein Herausbrechen bzw. - trennen der starre Lage 106 und der Teflonfolie 109 aus dem vorbestimmten Flächenabschnitt, so dass sich dadurch der biegbare Bereich 102 der Leiterplatte 101 ergibt. Die Deckschicht 108 schirmt in dem biegbaren Bereich 102 die biegbare Lage 104 und die darauf angeordnete Leiterbahnen o. dgl. ab.

Ein Nachteil einer herkömmlichen Leiterplatte 101 gemäß Fig. 5 besteht darin, dass angrenzend an den späteren biegbaren Bereich 102 eine Mehrzahl von Prepregs 105 auf der starren Lage 106 anzuordnen sind, um einen gleichmäßigen Flächendruck während des Heißpressvorgangs sicherzustellen. Ein weiterer Nachteil besteht darin, dass die Verwendung einer separaten Deckschicht 108 erforderlich ist, was zusätzlichen Aufwand beim Handling und erhöhte Materialkosten bedeutet.

Der Erfindung liegt die Aufgabe zugrunde, eine Leiterplatte und ein Verfahren zu deren Herstellung zu schaffen, wobei die Herstellung vereinfacht und preiswerter ist.

Diese Aufgabe wird durch eine Leiterplatte mit den Merkmalen von Anspruch 1 und durch ein Verfahren mit den Merkmalen von Anspruch 10 gelöst. Vorteilhafte weiterbildende Erfindungen sind in den anhängigen Ansprüchen definiert.

Eine erfindungsgemäße Leiterplatte umfasst mindestens einen biegbaren Bereich, der eine biegbare Lage aufweist, die ein- oder beidseitig mit einer Kupferkaschierung oder mit Leiterbahnen versehen ist. Die biegbare Lage ist zumindest in dem biegbaren Bereich und zumindest einseitig mit einer Deckschicht versehen, wobei diese Deckschicht aus einem Prepreg-Material gebildet ist.

Der Erfindung liegt die wesentliche Erkenntnis zugrunde, dass die Deckschicht, die in dem biegbaren Bereich auf der biegbaren Lage zum Abdecken der Kupferkaschierung bzw. der Leiterbahnen vorgesehen ist, anstelle aus einer herkömmlichen Kunststofffolie (z.B. Polyimid) nunmehr aus einem Prepreg-Material gebildet ist. Falls die biegbare Lage mit mindestens einer starren Lage mittels eines solchen Prepreg-Materials verbunden wird, kommt dem Prepreg-Material eine Doppelfunktion zu: Es dient sowohl als Klebemittel zwischen der biegbaren Lage und der starren Lage, und auch als Deckschicht für die biegbare Lage in dem biegbaren Bereich. Entsprechend ist es nicht notwendig, eine separate Folie oder dergleichen zur Bereitstellung einer Deckschicht für den biegbaren Bereich vorzusehen.

Eine bevorzugte Ausgestaltung gemäß Anspruch 2 sieht vor, dass die starre Lage im dem biegbaren Bereich ausgelassen bzw. entfernt ist. Der Bereich der Leiterplatte, der wie gewünscht biegbar werden soll, stellt einen vorbestimmten Flächenabschnitt der Leiterplatte dar, in dem die starre Lage entfernt ist. Hierdurch wird die gewünschte Biegbarkeit der Leiterplatte in ihrem biegbaren Bereich erzielt. Zur Vereinfachung der Herstellung der erfindungsgemäßen Leiterplatte ist es möglich, die starre Lage in dem biegbaren Bereich erst dann zu entfernen, wenn zuvor die starre Lage mit der biegbaren Lage flächig verbunden worden ist. Vorgefertigte Ausbruch- bzw. Sollbruchstellen in der starren Lage können das Entfernen der nicht verklebten starren Lage in dem vorbestimmten Flächenabschnitt erleichtern.

Im Sinne der Erfindung ist das Merkmal Lage als eine Schicht zu verstehen, die aus einer Einzellage, aus einer Mehrzahl von losen Einzellagen, oder aus einem Verbund aus bereits miteinander verbundenen bzw. verklebten Einzellagen bestehen kann. In dieser Hinsicht ist zu verstehen, dass die biegbare Lage und/oder die starre Lage in der genannten Weise ausgebildet sein können. Im vollständig fertiggestellten Zustand der erfindungsgemäßen Leiterplatte sind diese Lagen dauerhaft miteinander verbunden bzw. verklebt.

In vorteilhafter Weiterbildung der Erfindung nach Anspruch 3 kann die biegbare Lage zumindest eine Einzellage mit einer Dicke von 12,5 - 200 µm aufweisen. Diese Dicke entspricht einer vorgegebenen Biegbarkeit des biegbaren Bereichs und einer damit einhergehenden Festigkeit bzw. Stabilität. Zweckmäßigerweise kann die biegbare Lage auch aus einem Laminat, vorzugsweise einem zweilagigen Laminat hergestellt sein. Dieses Laminat besteht vorzugsweise aus zwei Lagen, die bereits miteinander verbunden sind, bevor ein weiteres Verbinden bzw. Verkleben mit der starren Lage erfolgt. Anders ausgedrückt, kann für die biegbare Lage eine vorkonfektionierte Lage, die aus einer Mehrzahl von Einzellagen besteht, verwendet werden. Es versteht sich, dass das Laminat für die biegbare Lage auch aus drei oder mehr Einzellagen bestehen kann, sofern eine Biegbarkeit für die biegbare Lage im fertiggestellten Zustand der Leiterplatte gewährleistet ist.

In vorteilhafter Weiterbildung der Erfindung gemäß Anspruch 5 weist die Deckschicht eine Dicke von 40 - 60 µm, vorzugsweise eine Dicke von 50 µm auf. Eine solche Dicke eignet sich für einen erforderlichen Schutz des biegbaren Bereichs bzw, der Kupferkaschierung/der Leiterbahnen, die auf der biegbaren Lage vorgesehen sind.

In vorteilhafter Weiterbildung der Erfindung gemäß Anspruch 6 kann das Prepreg-Material aus einem No-Flow-Prepreg oder zumindest aus einem Low-Flow-Prepreg bestehen. Die Handhabung von solchen Prepregs ist vergleichsweise einfach und erleichtert den Herstellungsprozess für die Leiterplatte.

Nach einer alternativen Weiterbildung der Erfindung gemäß Anspruch 7 kann das Prepreg-Material auch aus einem Full-Flow-Prepreg bestehen. Ein solches Prepreg-Material zeichnet sich durch gute Fließeigenschaften beim Verpressen unter Druck und Hitze aus. Entsprechend ist es möglich, mit einem Full-Flow-Prepreg-Material sehr gleichmäßige Flächenpressungen beim Herstellen der erfindungsgemäßen Leiterplatte zu erzielen, wodurch eine gleichmäßige Oberflächenqualität der fertiggestellten Leiterplatte erzielt wird.

Das erfindungsgemäße Verfahren zur Herstellung von Leiterplatten mit mindestens einem biegbaren Bereich und mit mindestens einem starren Bereich sieht vor, dass zwischen einer biegbaren Lage, die ein- oder beidseitig mit einer Kupferkaschierung oder mit Leiterbahnen versehen ist, und mindestens einer starren Lage ein flächiges Prepreg-Material und in einem vorbestimmten Flächenabschnitt der Leiterplatte Trennmittel, die an die starre Lage angrenzen, eingebracht werden. Anschließend wird ein Verpressen der jeweiligen Lagen durchgeführt, so dass daraus ein dauerhafter Verbund entsteht. Nach Abschluss des Pressvorgangs werden die starre Lage und die Trennmittel aus dem vorbestimmten Flächenabschnitt der Leiterplatte herausgetrennt, so dass sich dadurch der biegbare Bereich der Leiterplatte bildet. In dem biegbaren Bereich der Leiterplatte dient das Prepreg-Material als Deckschicht für die biegbare Lage.

Wesentlich für dieses Verfahren ist die Überlegung, dass das Prepreg-Material eine Doppelfunktion erfüllt: Es dient sowohl als Klebemittel zum Verbinden der biegbaren Lage mit der starren Lage, als auch zumindest in dem biegbaren Bereich als Deckschicht für die biegbare Lage. Somit ist es nicht erforderlich, bei der Herstellung der Leiterplatte in dem biegbaren Bereich für die biegbare Lage eine separate Deckschicht vorzusehen, was den Herstellungsprozess vereinfacht und die Kosten vermindert.

In vorteilhafter Weiterbildung des Verfahrens gemäß Anspruch 11 können die Trennmittel eine Dicke von 100 - 200 µm, vorzugsweise eine Dicke von 140 - 160 µm aufweisen. Hierdurch ist gewährleistet, dass sich die starre Lage aus dem vorbestimmten Flächenabschnitt der Leiterplatte, in dem der biegbare Bereich gebildet werden soll, sauber heraustrennen lässt, ohne dabei die Deckschicht in Form des Prepreg-Materials zu beschädigen. Desweiteren ist diese Dicke der Trennmittel auf das Verpressen der einzelnen Lagen abgestimmt, wenn dabei das Prepreg-Material seitlich von den Trennmitteln wegfließt.

Das erfindungsgemäße Verfahren kann in der Weise durchgeführt werden, dass die biegbare Lage und/oder die starre Lage aus einer Mehrzahl von losen Einzellagen bestehen, die beim anschließenden Verpressen der Lagen miteinander dauerhaft verbunden werden. Ein wesentlicher Aspekt hierbei ist, dass das Aufeinanderlegen der biegbaren Lage und der starren Lage, wobei das flächige Prepreg-Material und die Trennmittel dazwischen eingebracht werden, und das anschließende Verpressen der Lagen in einem einzigen Arbeitsgang erfolgt, was das Verfahren entsprechend preisgünstig macht. Alternativ hierzu können die biegbare Lage und/oder die starre Lage auch nur aus einer einzigen Einzellage oder aus einem vorkonfektionierten Verbund von Einzellagen bestehen, die beim Verpressen mit den jeweils angrenzenden Lagen dauerhaft verbunden werden.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist nachstehend anhand von bevorzugten Ausführungsformen in der Zeichnung schematisch dargestellt und wird unter Bezugnahme auf die Zeichnung ausführlich beschrieben. Es zeigen:
- Fig. 1: eine Querschnittsansicht einer erfindungsgemäßen Leiterplatte in fertiggestelltem Zustand mit asymmetrischem Aufbau,
- Fig. 2: eine Seitenansicht einer Mehrzahl von Lagen, die die Herstellung einer Leiterplatte von Fig. 1 verwendet werden,
- Fig. 3: eine Seitenansicht der Lagen von Fig. 2 während eines Pressvorgangs,
- Fig. 4: eine Querschnittsansicht einer weiteren Ausführungsform einer erfmdungsgemäßen Leiterplatte, mit symmetrischem Aufbau, und
- Fig. 5: eine Seitenansicht einer Mehrzahl von Lagen, zur Herstellung einer Leiterplatte nach dem Stand der Technik.

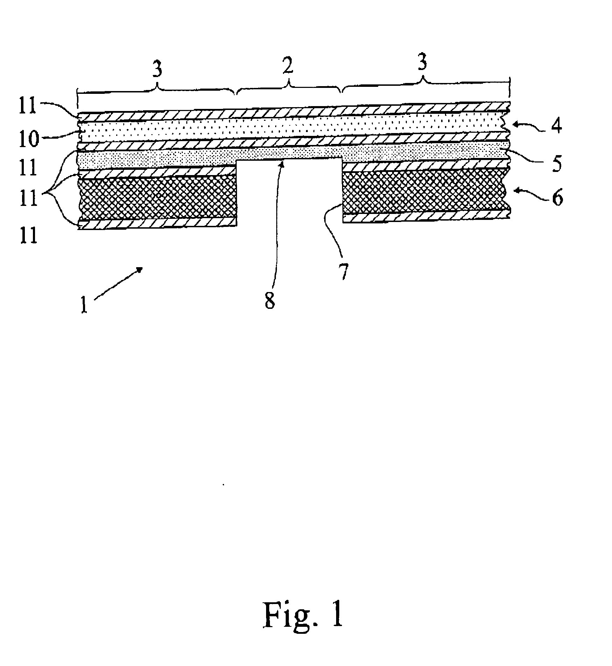

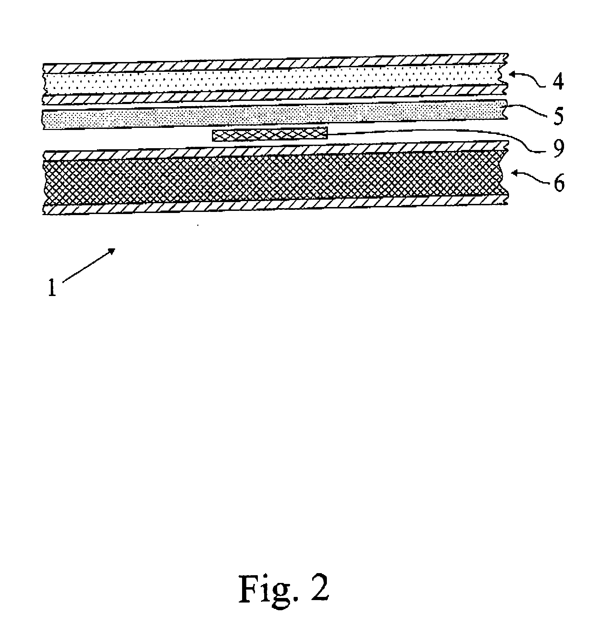

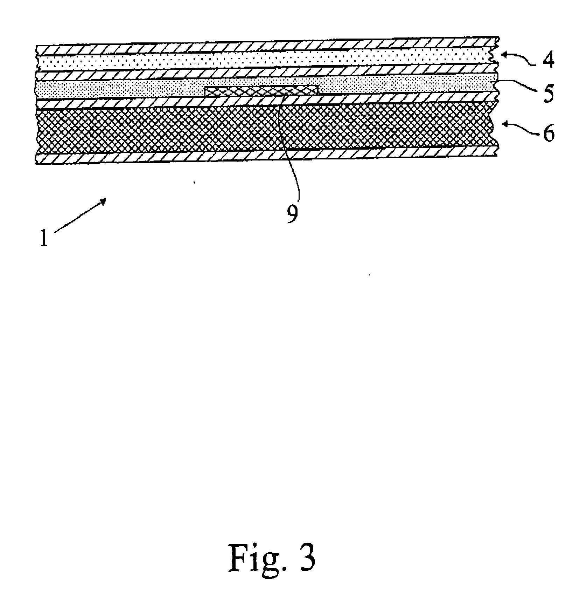

Fig. 1 zeigt eine Querschnittsansicht einer erfindungsgemäßen Leiterplatte 1, wobei in den Fig. 2 und 3 Fallschritte für ein Verfahren zur Herstellung einer solchen Leiterplatte dargestellt sind.

Die Querschnittsansicht von Fig. 1 verdeutlicht, dass die Leiterplatte 1 einen biegbaren Bereich 2 aufweist, an den jeweils starre Bereiche 3 angrenzen. Die starren Bereiche 3 sind hierbei durch den biegbaren Bereich 2 elektrisch miteinander verbunden. Die Leiterplatte 1 umfasst eine biegbare Lage 4, die mittels eines flächigen Prepreg-Materials 5 mit einer starren Lage 6 verbunden ist. Der Aufbau dieser Leiterplatte 1 ist in Bezug auf ihren Querschnitt asymmetrisch, da die starre Lage 6 an nur einer Seite der biegbaren Lage 4 vorgesehen ist.

In einem vorbestimmten Flächenabschnitt der Leiterplatte 1 ist die starre Lage 6 entfernt, woraus sich eine Ausnehmung 7 in der Leiterplatte 1 ergibt. Hieraus resultiert der biegbare Bereich 2 der Leiterplatten, da hier die starre Lage 6 entfernt ist und lediglich die biegbare Lage 4 in Verbindung mit dem Prepreg-Material 5 verbleibt. Das Prepreg-Material 5 bildet in dem biegbaren Bereich 2 eine Deckschicht 8, die die biegbare Lage 4 gegen die Ausnehmung 7 bzw. nach außen hin abschirmt. Somit erfüllt das Prepreg-Material 5 gleichzeitig zwei Funktionen, nämlich einerseits ein Verkleben der biegbaren Lage 4 mit der starren Lage 6, und andererseits in Form der genannten Deckschicht 8 ein Abschirmen der biegbaren Lage 4 zumindest in dem biegbaren Bereich 2.

Die biegbare Lage 4 ist aus einem geeigneten, dünnen, biegbaren Basismaterial gebildet, z. B. aus einem mehrlagigen Laminat. Eine mittlere Einzellage der biegbaren Lage 4 kann aus einer Polymid-Folie 10 bestehen, die eine Dicke von vorzugsweise 12,5 - 200 µm aufweisen kann. Diese Polymid-Folie 10 ist beidseitig mit einer Kupferkaschierung 11 versehen. Die Dicke der biegbaren Lage 4 ist geeignet so gewählt, dass in dem biegbaren Bereich 2 stets die gewünschte Biegbarkeit der Leiterplatte 1 gewährleistet ist. Mit diesem Basismaterial lassen sich für die biegbare Lage 4 kleinere Biegeradien und eine höhere Anzahl von Biegezyklen erzielen, als bei herkömmlichen biegbaren Bereichen einer Leiterplatte, die tiefengefräst sind.

Die Leiterbilder der biegbaren Lage 4 an deren innerer (d.h. in Fig. 1 unterer) Kupferkaschierung 11 werden vorgefertigt. Diese Leiterbilder werden in dem biegbaren Bereich 2 von der Deckschicht 8 geeignet abgeschirmt bzw. elektrisch isoliert. Entsprechend werden die Kupferkaschierung 11 bzw. die darauf gebildeten Leiterbahnen durch die Deckschicht 8 auch gegen mechanische Beschädigungen von außen geschützt.

In den Fig. 2 und 3 ist ein Verfahren zur Herstellung der Leiterplatte 1 gemäß Fig. 1 erläutert. In Fig. 2 sind die jeweiligen Lagen, aus denen die Leiterplatte 1 gebildet ist, vereinfacht und insbesondere nicht maßstabsgetreu übereinander geschichtet gezeigt. Dies entspricht im Wesentlichen einer Anordnung der Lagen in einem (nicht gezeigten) Presswerkzeug. Es ist zu erkennen, dass das Prepreg-Material 5 flächig ausgebildet ist, so dass es im Wesentlichen die gleiche Erstreckung wie die biegbare Lage 4 und die starre Lage 6 aufweist. Das Prepreg-Material 5 wird vor dem Verpressen zwischen die biegbare Lage 4 und die starre Lage 6 eingebracht. Zusätzlich werden geeignete Trennmittel, z. B. in Form einer Teflon-Folie 9, ebenfalls zwischen die biegbare Lage 4 und die starre Lage 6 eingebracht, wobei die Teflon-Folie 9 dabei an die starre Lage 6 angrenzt. Ausgehend von der Konfiguration gemäß Fig. 2 wird anschließend ein Heißpressvorgang durchgeführt, um die jeweiligen Lagen miteinander dauerhaft zu verbinden.

Alternativ zu der Teflon-Folie 9 kann als Trennmittel auch ein Gel oder ein fließfähiger Klebstoff verwendet werden. Dieses Gel bzw. der fließfähige Klebstoff können z. B. mittels Siebdruck auf die starre Lage 6 aufgebracht werden.

Fig. 3 verdeutlicht die Durchführung des vorstehend genannten Heißpressvorgangs zur Herstellung der Leiterplatte 1.

Mittels eines geeigneten (nicht gezeigten) Werkzeugs werden die jeweils äußeren Lagen der Leiterplatte 1, d.h. die biegbare Lage 4 und die starre Lage 6 in Richtung zueinander gedrückt bzw. gepresst. Infolge des aufgebrachten Drucks wird das Prepreg-Material 5 an einer Oberseite der Teflon-Folie 9 teilweise zur Seite hin verdrängt. Das verdrängte Material des Prepreg-Materials 5 füllt seitlich die Abschnitte zwischen der biegbaren Lage 4 und der starren Lage 6 auf, so dass im Ergebnis ein gleichmäßiger Flächendruck beim Verpressen der Lagen erzielt wird. Die Darstellung von Fig. 3 ist ebenfalls vereinfacht zu verstehen, insbesondere im Hinblick auf eine Verformung des Prepreg-Materials 5 während des Pressvorgangs.

Die Teflon-Folie 9 erfüllt die Funktion einer Isolations- bzw. Trennfolie, wodurch verhindert wird, dass die starre Lage 6 im Bereich der Teflon-Folie mit der biegbaren Lage 4 verklebt wird. Nach Abschluss des Heißpressvorgangs wird in dem vorbestimmten Flächenabschnitt der Leiterplatte 1, der dem gewünschten biegbaren Bereich 2 entspricht, die starre Lage 6 in Verbindung mit der Teflon-Folie 9 entfernt. Nach dem Heraustrennen der starren Lage 6 und der Teflon-Folie 9 aus dem vorbestimmten Flächenabschnitt der Leiterplatte 1 ergibt sich die in Fig. 1 gezeigte Ausnehmung 7. Wie unter Bezugnahme auf Fig. 1 erläutert, ist die Leiterplatte 1 im Bereich der Ausnehmung 7 biegbar, wobei das Prepreg-Material 5 in dem biegbaren Bereich 2 gleichzeitig als Deckschicht 8 für die biegbare Lage 4 dient.

Beim Verpressen der Lagen wird die Teflon-Folie 9 in das Prepreg-Material 5 hineingedrückt, wobei Prepreg-Material 5 von einer Oberseite der Teflon-Folie 9 wie erläutert teilweise zur Seite hin verdrängt wird. In Folge dessen ist die Dicke des Prepreg-Materials 5 oberhalb der Teflon-Folie 9 nach Abschluss des Pressvorgangs vermindert, wie die Darstellung von Fig. 3 zeigt. Nach dem Entfernen der starren Lage 6 und der Teflon-Folie 9 in dem biegbaren Bereich 2 ergibt sich an den Rändern der Deckschicht 8 eine Stufe , wobei die Höhe dieser Stufe im Wesentlichen der Dicke der Teflon-Folie 9 entspricht, die sich vormals in diesem Bereich befunden hatte.

Alternativ zu dem Verfahrensablauf gemäß der Fig. 2 und 3 ist es auch möglich, vor dem Verpressen der Lagen 4, 6 zusätzliche Prepreg-Lagen zwischen die biegbare Lage 4 und die starre Lage 6 einzubringen, nämlich seitlich von der Teflon-Folie 9. Diese zusätzlichen Prepreg-Lagen werden in den Abschnitten der Leiterplatte 1 eingebracht, die den späteren starren Bereichen entsprechen, und weisen im Wesentlichen die gleiche Höhe wie die Teflon-Folie 9 auf. Vorzugsweise bestehen diese zusätzlichen Prepreg-Lagen aus No-Flow-Prepregs, was deren Handling wesentlich vereinfacht. Die zusätzlichen Prepreg-Lagen gleichen beim Verpressen der Lagen den Höhenunterschied zur Teflon-Folie 9 aus, so dass sich die Teflon-Folie 9 im Unterschied zur Darstellung von Fig. 3 nicht so stark bzw. gar nicht in das Prepreg-Material 5 in dem Abschnitt des späteren biegbaren Bereichs 2 hineindrückt. Im Ergebnis bildet sich an den Rändern der Deckschicht 8 auch keine Stufe, wenn die starre Lage 6 in Verbindung mit der Teflon-Folie 9 aus dem biegbaren Bereich 2 entfernt worden sind.

Bezüglich der biegbaren Lage 4 und/oder der starren Lage 6 ist zu verstehen, dass diese Lagen verschiedenartig ausgebildet sein können. Entweder sind die Lagen 4, 6 jeweils durch eine Einzellage gebildet. Alternativ hierzu können die Lagen 4, 6 auch aus einer Mehrzahl von losen Einzellagen, oder auch aus einem Verbund von bereits zuvor verbundenen Einzellagen gebildet sein. Wesentlich für das Verfahren zur Herstellung der Leiterplatte 1 ist, dass das Übereinander-Schichten der jeweiligen Lagen und das anschließende Verpressen der Lagen in einem einzigen Arbeitsvorgang durchgeführt werden kann, ungeachtet der jeweiligen Ausgestaltung der entsprechenden Lagen. Dies führt zu einer wesentlichen Erleichterung der Herstellung und somit auch zu Kosteneinsparungen.

Das Verfahren zur Herstellung der Leiterplatte 1 zeichnet sich auch dadurch aus, dass die hierzu verwendeten Lagen vor der Bestückung des Presswerkzeugs nicht getrocknet werden müssen. Bei Verwendung von losen Einzellagen können diese ohne weitere Vorbereitung einfach übereinander gelegt werden. Dies vermindert die Taktzeit bei der Herstellung und somit auch die Kosten.

Bei dem Prepreg-Material 5 kann es sich um ein Material mit der Bezeichnung Isola Duraver®-E-Cu in der Qualität 104 ML 106 AT05 handeln. Die Harzformulierung dieses Materials weist eine hohe thermische Beständigkeit auf und ist chemikalienbeständig, was die Gefahr von Harzrückzug auf ein Minimum reduziert. Desweiteren wird bei diesem Material ein übermäßiges Rückätzen in Bohrlöchern, die in der Leiterplatte 1 vorgesehen sein können, verhindert, wodurch sich eine hohe Zuverlässigkeit der Durchkontaktierung, auch unter zyklischer Belastung, ergibt.

Die starre Lage 6 ist in gleicher Weise wie die biegbare Lage 4 beidseitig mit einer Kupferkaschierung 11 versehen. Alternativ hierzu ist es möglich, dass die starre Lage 6 auf nur einer Seite mit einer Kupferkaschierung versehen ist. Durch (nicht gezeigte) Bohrlöcher in der Leiterplatte 1 wird eine Durchkontaktierung der Kupferkaschierungen 11, die auf der biegbaren Lage 4 und auf der starren Lage 6 vorgesehen sind, erreicht.

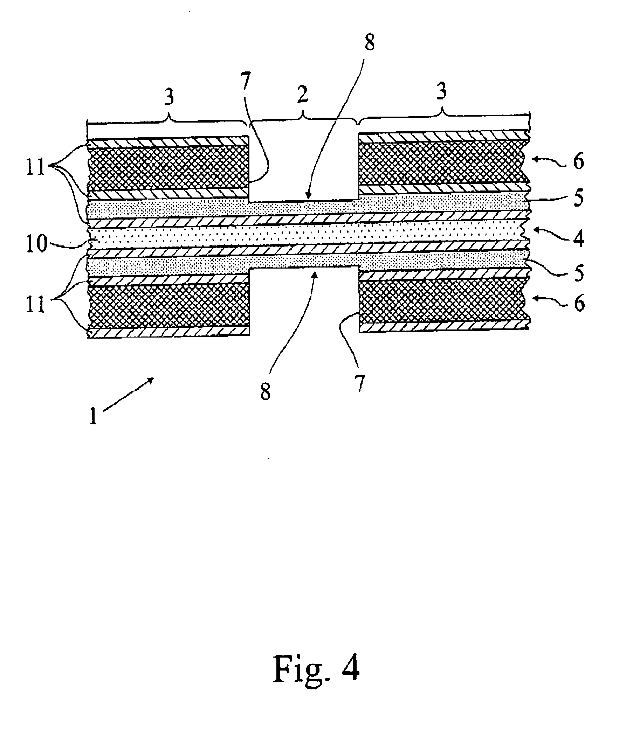

In Fig. 4 ist eine weitere Ausführungsform der erfindungsgemäßen Leiterplatte 1 gezeigt. Gleiche Merkmale wie bei der vorstehend erläuterten Ausführungsform sind hierbei mit gleichen Bezugszeichen versehen. Im Unterschied zur Ausführungsform von Fig. 1 weist die Ausführungsform gemäß Fig. 4 einen symmetrischen Aufbau in Bezug auf ihren Querschnitt auf. Dies bedeutet, dass auf beiden Seiten der biegbaren Lage 4 jeweils eine starre Lage 6 vorgesehen ist. Die beiden starren Lagen 6 sind durch ein jeweiliges Prepreg-Material 5 mit der biegbaren Lage 4 verbunden. Die Ausnehmungen 7, die in den jeweiligen starren Lagen 6 ausgebildet sind, sind zweckmäßigerweise miteinander fluchtend angeordnet, so dass sich für den biegbaren Bereich 2 ein hohes Maß an Biegbarkeit einstellt.

Die erfindungsgemäße Leiterplatte 1 zeichnet sich dadurch aus, dass der biegbare Bereich 2 asymmetrisch (vgl. Fig. 1) oder symmetrisch (vgl. Fig. 4) in dem Aufbau der Leiterplatte 1 angeordnet sein kann. Gegenüber einer herkömmlichen tiefengefrästen Ausführung einer Leiterplatte kann hierbei die Biegerichtung für die Leiterplatte 1 frei gewählt werden. Desweiteren ist bei der Leiterplatte 1 nicht erforderlich, für den biegbaren Bereich ein Glasfasergewebe anzufräsen, so dass keine Sollbruchstelle entsteht. Hieraus resultiert eine höhere Qualität und Zuverlässigkeit gegenüber einem tiefengefrästen Herstellungsverfahren. Schließlich bietet die biegbare Lage 4, die wie vorstehend erläutert aus einem geeigneten dünnen biegbaren Basismaterial besteht, gegenüber tiefengefrästen herkömmlichen Leiterplatte den Vorteil von kleineren Biegeradien und einer höheren Anzahl von Biegezyklen.

## Patentansprüche

1. Leiterplatte (1) mit mindestens einem biegbaren Bereich (2), der eine biegbare Lage (4), die ein- oder beidseitig mit einer Kupferkaschierung (11) oder mit Leiterbahnen versehen ist, aufweist, wobei die biegbare Lage (4) zumindest in dem biegbaren Bereich (2) und zumindest einseitig mit einer Deckschicht (8) versehen ist,
**dadurch gekennzeichnet,**
**dass** die Deckschicht (8) aus einem Prepreg-Material (5) gebildet ist.

2. Leiterplatte (1) nach Anspruch 1, **dadurch gekennzeichnet, dass** die Leiterplatte (1) mindestens einen starren Bereich (3) mit einer starren Lage (6) aufweist, wobei die starre Lage (6) und die biegbare Lage (4) mittels des Prepreg-Materials (5), das die Deckschicht (8) in dem biegbaren Bereich (2) bildet, miteinander verbunden sind, vorzugsweise, dass die starre Lage (6) in dem biegbaren Bereich (2) ausgelassen bzw. entfernt ist.

3. Leiterplatte (1) nach einem der vorhergehenden Ansprüche, **dadurch gekennzeichnet, dass** die biegbare Lage (4) zumindest eine Einzellage mit einer Dicke von 12,5 - 200 µm aufweist.

4. Leiterplatte (1) nach einem der vorhergehenden Ansprüche, **dadurch gekennzeichnet, dass** die biegbare Lage (4) aus einem Laminat, vorzugsweise aus einem zwei- oder mehrlagigen Laminat (10, 11) hergestellt ist.

5. Leiterplatte (1) nach einem der vorhergehenden Ansprüche, **dadurch gekennzeichnet, dass** die Deckschicht (8) eine Dicke von 40-60 µm, vorzugsweise eine Dicke von 50 µm aufweist.

6. Leiterplatte (1) nach einem der vorhergehenden Ansprüche, **dadurch gekennzeichnet, dass** das Prepreg-Material (5) aus einem No-Flow-Prepreg oder zumindest aus einem Low-Flow-Prepreg besteht.

7. Leiterplatte (1) nach einem der vorhergehenden Ansprüche, **dadurch gekennzeichnet, dass** das Prepreg-Material (5) aus einem Full-Flow-Prepreg besteht.

8. Leiterplatte (1) nach einem der Ansprüche 2 bis 7, **dadurch gekennzeichnet, dass** die starre Lage (6) ein- oder beidseitig mit einer Kupferkaschierung (11) oder mit Leiterbahnen versehen ist.

9. Leiterplatte (1) nach einem der vorhergehenden Ansprüche, **dadurch gekennzeichnet, dass** die biegbare Lage (4) und/oder die starre Lage (6) jeweils aus einer Einzellage, aus einer Mehrzahl von Einzellagen oder aus einem Verbund von Einzellagen bestehen, die nach dem Verpressen Teil der Leiterplatte (1) in Form einer Mehrlagenleiterplatte (1) sind.

10. Verfahren zur Herstellung von Leiterplatten (1) mit mindestens einem biegbaren Bereich (2) und mit mindestens einem starren Bereich (3), bei dem zwischen einer biegbaren Lage (4), die ein- oder beidseitig mit einer Kupferkaschierung (11) oder mit Leiterbahnen versehen ist, und mindestens einer starren Lage (6) ein flächiges Prepreg-Material (5) und in einem vorbestimmten Flächenabschnitt der Leiterplatte Trennmittel (9), die an die starre Lage (6) angrenzen, eingebracht werden, und anschließend ein Verpressen der Lagen (4, 5, 6) zu einem dauerhaften Verbund durchgeführt wird, wobei nach dem Verpressen die starre Lage (6) und die Trennmittel (9) aus dem vorbestimmten Flächenabschnitt der Leiterplatte (1) herausgetrennt werden, so dass sich dadurch der biegbare Bereich (2) der Leiterplatte (1) bildet, wobei in dem biegbaren Bereich der Leiterplatte (1) das Prepreg-Material (5) als Deckschicht (8) für die biegbare Lage (4) dient.

11. Verfahren nach Anspruch 10, **dadurch gekennzeichnet, dass** die Trennmittel (9) eine Dicke von 100-200 µm, vorzugsweise eine Dicke von 140-160 µm aufweisen.

12. Verfahren nach Anspruch 10 oder 11, **dadurch gekennzeichnet, dass** die Trennmittel (9) aus einer Teflonfolie (9), aus einem Gel oder aus einem fließfäbigem Klebstoff bestehen.

13. Verfahren nach einem der Ansprüche 10 bis 12, **dadurch gekennzeichnet, dass** das Einbringen des flächigen Prepreg-Materials (5) und der Trennmittel (9) zwischen die biegbare Lage (4) und die starre Lage (6) und das anschließende Verpressen der Lagen in einem einzigen Arbeitsvorgang erfolgt, so dass hierbei ein dauerhaftes Verbinden der Lagen zu einer Mehrlagenleiterplatte (1) erfolgt.

14. Verfahren nach einem der Ansprüche 10 bis 13, **dadurch gekennzeichnet, dass** die biegbare Lage (4) und/oder die starre Lage (6) aus einer Mehrzahl von Einzellagen bestehen, die beim Verpressen der Lagen miteinander verbunden werden.

15. Verfahren nach einem der Ansprüche 10 bis 14, **dadurch gekennzeichnet, dass** die biegbare Lage (4) und/oder die starre Lage (6) aus einer Einzellage oder aus einem vorkonfektionierten Verbund von Einzellagen bestehen, die beim Verpressen der Lagen mit den jeweils angrenzenden Lagen dauerhaft verbunden werden.
